# EUROPEAN PATENT SPECIFICATION

(11) **EP 3 106 426 B1**
(45) Date of publication and mention of the grant of the patent: **06.11.2019**
(21) Application number: 15173033.0
(22) Date of filing: 19.06.2015
(51) Int. Cl.: B81C 1/00, G01L 9/00, G01L 19/14, G01L 19/00

(54) **PRESSURE SENSOR**
DRUCKSENSOR
CAPTEUR DE PRESSION

(43) Date of publication of application: 21.12.2016
(73) Proprietor: Invensense, Inc., San Jose, California 95110 (US)
(72) Inventor: MAYER, Felix, 8712 Staefa ZH (CH); SCHUMM, Johannes, 8712 Staefa ZH (CH)
(74) Representative: Smith, Jeremy Robert

(56) References cited:
- EP-A1- 2 871 455
- EP-A2- 0 633 459
- US-A- 4 769 738
- US-A- 5 344 523
- US-A1- 2010 171 153
- US-A1- 2015 122 042

## Description

The present invention relates to a pressure sensor as well as to a method for manufacturing such a pressure sensor.

US5,344,523A concerns a capacitive differential pressure sensing device with pressure overrange protection. In one arrangement, a cavity is formed as a two-step recess with an electrically conductive diaphragm between the upper recess and the lower recess.

Pressure sensors are also described in US2010/171153A1, EP0633459A2, US4,769,738A, EP2871455A1 and US2015/122042A1.

Typically, such a pressure sensor for sensing a pressure in a surrounding of the pressure sensor comprises a substrate comprising a cavity and an elastically deformable membrane that is configured to be deformed in response to a pressure acting on the membrane, wherein said membrane separates said cavity from a space that communicates with the ambient pressure of the surrounding so that said ambient pressure actually acts on the membrane. Further, said membrane comprises a first electrode that opposes a second membrane arranged at the bottom of the cavity. Due to the pressure to be sensed that acts on the membrane, the latter is deformed so that a distance (e.g. central or average distance) between the first and the second electrode depends on said pressure to be sensed. Hence, via measuring the capacitance between said two electrodes which depends on said distance between the electrodes the pressure acting on the membrane can be determined.

Several techniques are known in the state of the art for manufacturing cavities and particularly membranes closing such cavities. In US8,334,188B2 and EP1324382A1 an opening is formed in a region of a monocrystalline semiconductor layer and an epitaxial layer is formed on the semiconductor layer such that the opening is converted into a cavity encapsulated by monocrystalline semiconductor material during the forming of said epitaxial layer. Thereafter, upon annealing of said region said cavity gets its final shape.

Further, in US7,479,232B2 a cavity is generated by electrochemically etching small pores in a silicon substrate using a mask to form a first porous layer in the silicon substrate and thereafter a cavity under the first porous layer by means of further electrochemical etching, wherein the first porous layer is annealed and an epitaxial layer is deposited on top of the first porous layer.

Particularly, in the examples above, the epitaxial layer is used for forming the membrane.

The monocrystalline cavities described above and further below have the advantage that they are fully sealed and thus prevent e.g. Helium and Hydrogen from leaking into the cavity which assures a long term stability of the final pressure sensor.

Further, according to EP1860417B1, it is also possible to generate a sealed or tight cavity by forming a recess in a surface of the substrate and by attaching a further substrate to said surface so as to cover said recess and form said cavity. Here, the further substrate is used for forming said membrane. The cavity may then be sealed using a gasket that may be made e.g. out of a metal or SiN.

Usually, piezoresistive measuring techniques are employed for constructing pressure sensors in conjunction with monocrystalline cavity designs (e.g. US7,479,232B2). Unfortunately, due to their nature, such techniques are temperature dependent and power consuming.

Therefore, based on the above, the problem underlying the present invention is to provide a pressure sensor that allows to use a capacitive measuring technique with a tight cavity, e.g. of the afore-mentioned kind.

This problem is solved by a pressure sensor having the features of claim 1. Preferred embodiments are stated in the corresponding sub claims and are further described below.

According to claim 1, the pressure sensor according to the invention comprises:
a first substrate comprising a cavity and a deformable membrane that is configured to be deformed by a pressure acting on the membrane, wherein said membrane separates said cavity from a gap of the pressure sensor, wherein said gap communicates with a surrounding of the pressure sensor so that the pressure in said gap corresponds to the pressure in said surrounding,
a first electrode comprised or formed by said membrane, wherein the first electrode is moveable with the membrane, and
a stationary second electrode which faces said first electrode, wherein said gap is arranged between the second electrode and said membrane comprising the first electrode, so that a distance between the first electrode and the second electrode depends on the pressure in said gap,
wherein the pressure sensor comprises several through holes via which said gap communicates with said surrounding of the pressure sensor, wherein said through holes extend through the first substrate,
wherein said through holes extend to separate a first portion of the first substrate from a surrounding second portion of the first substrate, and wherein said first portion is connected via suspension elements to the surrounding second portion of the first substrate.

In an embodiment of the invention, the second electrode is comprised by a second substrate, e.g. the second electrode is attached to or formed by the second substrate. In an alternative embodiment, the second electrode is held by a holding means that may itself be connected to the first substrate or may protrude from the first substrate. Particularly, said holding means can be formed integrally with the first substrate. Particularly, the first substrate is made out of or comprises a semiconductor material, e.g. Si. Further, particularly, also the second substrate is made out of or comprises a semiconductor material, e.g. Si. Other suitable materials are also possible. The second substrate may, for example, contain a bulk material made e.g. from silicon and various layers stacked on the bulk material such as one or more of metal layers, insulation layers and passivation layers, which may be used for CMOS processing a processing circuit integrated into the second substrate (see below).

Particularly, the first and the second substrate both extend along an extension plane and may in particular comprise a larger dimension along the respective extension plane than perpendicular to the respective extension plane. Particularly, said two substrates (said extension planes) extend parallel to each other. Further, also the two electrodes extend along or parallel to the respective extension plane of the associated substrate. Said distance between the electrodes that depends on the pressure in said gap particularly extends along a direction that runs perpendicular to said extension planes, said electrodes, or said substrates. Further, said gap extends between said first and second substrate, i.e. along said extension planes.

Each substrate comprises a front side and a back side facing away from the respective front side, wherein, by definition, the membrane is arranged on the front side of the first substrate which front side faces the back side of the second substrate.

Particularly, said cavity is a tight or substantially tight cavity, i.e. it is sealed so that preferably no gas, particularly hydrogen or helium, or merely negligible/tolerable amounts of gas can leak into the cavity. Such a cavity, and particularly said membrane covering/closing the cavity, can be formed by any suitable process.

Particularly, according to an embodiment of the present invention, said cavity is a tight monocrystalline cavity, i.e., the cavity is enclosed from all sides by monocrystalline (e.g. semiconductor) material (e.g. Si).

Particularly, said cavity is manufactured by forming a recess in the front side of the first substrate (e.g. by electrochemical etching) and by depositing an epitaxial layer of semiconductor material (e.g. Si) on the front side covering said recess so that said recess is converted into said cavity encapsulated by monocrystalline (e.g. semiconductor) material (e.g. Si). Thereafter, a region of the first substrate comprising the cavity or the whole first substrate may be annealed whereby the cavity receives its final shape.

Alternatively, a plurality of trenches may be formed in the front side of the first substrate and covered by depositing an epitaxial layer on the front side covering said trenches, which are then formed into one cavity upon annealing of the region of the first substrate comprising said trenches.

Further, alternatively, said cavity may be generated by forming (e.g. electrochemically etching) small pores in the front side of the first substrate (e.g. using a mask) to form a first porous layer in the first (e.g. Si) substrate and thereafter a cavity under the first porous layer by means of electrochemical etching, wherein the first porous layer is annealed and an epitaxial layer is deposited on top of the first porous layer to cover the cavity.

Particularly, the material covering the cavity and facing the gap, e.g. the epitaxial layer in the examples above, forms said membrane or at least a part of said membrane. Further, particularly said first electrode may be formed by the membrane which may comprise for this purpose electrically conducting material, e.g. a doped semiconducting epitaxial layer (e.g. doped Si) arranged above the cavity, a metal layer attached on or comprised by the membrane covering said cavity, or a polysilicon layer of the membrane.

Further, also the second electrode is formed by electrically conducting material of the second substrate such as a metal layer, a doped semiconducting layer (e.g. doped Si), or a polysilicon layer.

Further, alternatively, said (tight) cavity may be formed according to an embodiment by forming a recess in the front side of the first substrate and by attaching a further third substrate to said front side of the first substrate so as to cover said recess and form said cavity. Here, the further third substrate is used for forming said membrane.

Further, the cavity may be sealed using a circumferential gasket that may be made out of a metal or SiN or may comprise at least one of these materials.

The third substrate can be an SOI (Silicon On Insulator) substrate, wherein particularly the deformable membrane may be built from a silicon layer of the SOI substrate while an insulation layer and bulk material of the SOI substrate are removed during formation of the membrane. Also here, the first electrode can be formed as described above.

Since the first and second electrode face each other via said gap arranged between them, they are both exposed to humidity of the environment/surrounding of the pressure sensor. This may lead to an accelerated aging of the electrodes. In order to protect the electrodes, the first and/or second electrode may be covered by a suitable (e.g. known) protective coating.

According to an embodiment of the present invention, the pressure sensor comprises an integrated processing circuit or is at least configured to be connected to a processing circuit, particularly a CMOS processing circuit, which is configured to measure a capacitance between the first and the second electrode, wherein particularly the processing circuit is configured to derive an output signal from said capacitance corresponding to the pressure in said gap and therefore to the pressure in said surrounding (e.g. vicinity) of the pressure sensor.

According to an embodiment of the present invention, the processing circuit is integrated into the second substrate. Particularly, the processing circuit is fabricated in the second substrate by a CMOS process, e.g. following well-known steps of processing said layers of the second substrate (see also above). In an alternative embodiment the processing circuit may be integrated into the first substrate.

Further, according to an embodiment of the present invention, the pressure sensor comprises electrical contacts that are configured for electrically connecting the pressure sensor, particularly the processing circuit, to a further device. Particularly, the pressure sensor is configured to deliver said output signal of the processing circuit to said electrical contacts by means of a suitable electrically conducting connection between the processing circuit and said electrical contacts. Particularly, said electrical contacts each support a solder ball for connecting to external devices.

Further, according to an embodiment of the present invention, the electrical contacts are arranged on the first substrate, particularly on the back side facing away from the front side on which said membrane is arranged, and are each electrically connected to a via, which via may be a TSV, i.e., a Through-Silicon Via, which vias extend at least partially or completely through the first substrate.

Alternatively, the electrical contacts are arranged on the second substrate, particularly on the front side of the second substrate facing away from said membrane, and are each electrically connected to a via (e.g. TSV), which vias extend at least partially or completely through the second substrate.

It is to be noted that the electrical contacts can also be electrically connected to the processing circuit in any other suitable way, particularly by means of electrical conductors that extend on an e.g. lateral outside of the pressure sensor e.g. from the first substrate to the second substrate.

Further, according to an embodiment of the present invention, the second substrate is supported via spacers on the first substrate. Particularly, one, several or all spacers may also form part of said electrically conducting connection between the processing circuit and said electrical contacts.

Further, particularly, there is also provided an electrically conducting connection between the electrodes and the processing circuit for measuring the capacitance between the electrodes. Here, for instance, at least one spacer may form part of an electrically conducting connection between the first electrode and the processing circuit.

Furthermore, according to an embodiment of the present invention, the pressure sensor comprises at least one opening on an outside of the pressure sensor, via which opening said gap communicates with said surrounding of the pressure sensor, i.e., is in flow connection with the surrounding of the pressure sensor.

Particularly, the pressure sensor comprises at least one lateral opening via which said gap communicates with said surrounding of the pressure sensor. Here, particularly, said at least one lateral opening is arranged on a lateral side of the pressure sensor that extends e.g. perpendicular to said extension planes of the substrates described above and is e.g. delimited by the first and the second substrate.

Preferably, the several through holes are configured to form stress insulation trenches. Particularly, in order to achieve this, said e.g. elongated through holes extend such that they separate a first portion of the first substrate from a surrounding second portion of the first substrate such that said first portion is merely (e.g. integrally) connected via suspension elements or regions to the surrounding second portion of the first substrate.

According to an embodiment of the present invention, the first portion comprises at least one of, particularly all of: the cavity, said membrane.

Further, particularly, the second substrate is supported on the second portion of the first substrate via said spacers and particularly comprises said vias extending through the second portion, which vias may be connected to an associated electrical contact lying outside the first portion of the first substrate via a conductor. Particularly, the pressure sensor is configured to be solely connected mechanically and electrically to further devices via said second portion (e.g. by a connection using the solder balls).

Advantageously, the second portion of the pressure sensor via which mechanical stress is induced is mechanically decoupled from the first portion (housing said cavity) due to said trenches.

According to a preferred embodiment, said through holes are formed as elongated (particularly curved) through holes that each extend in a peripheral direction of the first portion of the first substrate, wherein each suspension element comprises a portion that is arranged between two neighbouring elongated through holes in a (radial) direction running perpendicular to said peripheral direction. In other words, also the suspension elements comprise a portion, respectively, that extends in the peripheral direction of the first portion accommodating the cavity and the membrane/first electrode. Particularly, the suspension element may be integrally formed with the first and second portion of the first substrate, and may simply be generated by forming said through holes in the corresponding (e.g. first) substrate. As an example, a total height of the pressure sensor in a direction perpendicular to said extension planes of the first and second substrate may be in the range from 350 microns to 800 microns.

Furthermore, according to a further aspect of the present invention, the problem underlying the present invention is solved by a method for manufacturing a pressure sensor according to the invention, having the features of claim 13.

According to claim 13, a method for manufacturing a pressure sensor according to any of claims 1 to 12 is provided, wherein at least a first substrate is provided, wherein a cavity is formed in the first substrate, wherein a deformable membrane closing said cavity and comprising a first electrode is formed, wherein a second electrode is provided, and wherein the first substrate and the second electrode are connected such that the second electrode faces the first electrode and a gap is formed between the two electrodes that communicates with a surrounding of the pressure sensor and wherein several though holes are formed into the first substrate such that they extend to separate a first portion of the first substrate from a surrounding second portion of the first substrate such that said first portion of the first substrate is connected via suspension elements to the surrounding second portion of the first substrate.

The cavity and membrane can be formed e.g. as described above. This may involve an additional (third) substrate for closing the cavity and forming the membrane. Particularly, before mounting the second substrate or second electrode to the first substrate (particularly with the additional (third) substrate as an intermediary substrate if present), a processing circuit, particularly a CMOS processing circuit, which is configured to measure a capacitance between the first and the second electrode (see e.g. above) is integrated into the first or into the second substrate, particularly by means of a known CMOS process.

The manufacturing of the several through holes may be performed in different ways. Particularly, the first substrate may be pre-processed prior to being attached to the second substrate or second electrode by forming (e.g. etching) said through holes from e.g. the front side of the first substrate therein.

Alternatively, the through holes may not be manufactured at a sufficient depth for reaching through the entire bulk material of the first substrate. Hence, there may be another processing step required to finally open the pre-stage of the final through holes from the back side of the first substrate, i.e. opposite to the front side that finally faces the second electrode (e.g. of the second substrate). In this embodiment, it is preferred that the pre-stage of the through holes is manufactured prior to attaching the second substrate to the first substrate while the pre-stage of the through holes is laid open from the back side of the first substrate after having attached the second substrate to the first substrate.

Further, electrically conducting vias are provided, particularly in the first substrate, for electrically connecting the second substrate and its (e.g. integrated) processing circuit to electrical contacts (e.g. at the back side) of the first substrate.

Particularly, the vias are provided in the first substrate after having mounted the second substrate to the first substrate and prior to opening the pre-stage of said through hole in the first substrate if required.

In a particular variant of the invention, the one or more vias are made using a TSV (Through Silicon Via) process. Such vias are denoted as TSV, see also above. Prior to e.g. etching the holes for the vias into the first substrate, a thickness of the first substrate may be reduced, e.g. down to 150 micron or less rendering it more suitable for TSV or similar processes. When reducing the thickness of the first substrate the second substrate may protect the deformable membrane and other sensitive structures.

Particularly, in an embodiment of the present invention, the method may be conducted on a wafer scale, i.e. multiple pressure sensors are manufactured in the same manufacturing steps on the same wafer. At one point in time, e.g. at the very end, the individual pressure sensors are separated from each other by dicing the wafer stack. Prior to the separation step, a second wafer is provided with multiple processing circuits being pre-processed thereon, as well as a first wafer corresponding to the first substrate (and particularly, as the case may be, a third wafer corresponding to the third substrate for forming the membrane). The processing circuits are manufactured in the second wafer and the cavities are manufactured in the first wafer. Further, particularly, in case a third wafer is used, the first wafer is attached to the third wafer for processing the deformable membranes. The assembly of the first and the third wafer may then be mounted to the second wafer with the deformable membranes facing the second wafer.

Alternatively, in case no third wafer is used, the cavities and membranes may be formed in the first wafer and afterwards the first wafer is attached to the second wafer. The first wafer may be pre-processed with said through holes for accessing the gaps between the first and the second electrodes reaching into or through the first wafer. Particularly, having assembled the first and second (and, as the case may be, third) wafers, the first wafer may then continued to be processed from its back side, e.g. by manufacturing said vias. Particularly, in case the through holes prepared in the first wafer do not yet reach through it (e.g. pre-stages), the laying open of the through holes is performed from the back side of the first wafer, particularly after having manufactured the vias, however, still on wafer-scale. At the very end, the wafer stack may be separated into individual pressure sensors according to the invention.

The individual devices (pressure sensors) are preferably individually calibrated at different, pre-defined pressures and temperatures. These calibrations can be performed on the wafer level, on the die level or for the packaged device, for instance using a method as disclosed in EP 2 259 027 B1.

Preferably, said individual calibrating serves for compensating variations among the pressure sensors, e.g. in said distance between the two electrodes.

According to an embodiment, the pressure sensor may therefore comprise a means for storing calibration data derived from the calibration measurements. This may e.g. be in the form of a look-up table, for instance as disclosed in WO 0 158 019 A1. In one embodiment, some calibration steps may be performed on the wafer level and some on the packaged device, for instance using a method as disclosed in EP 2 827 145 A1. Further features and advantages of the present invention will be described below with reference to the Figures which show embodiments of the present invention, wherein
- Fig. 1: shows a schematic cross sectional view of a pressure sensor according to an example; and
- Fig. 2: shows a schematic cross sectional view of a pressure sensor according to the invention having at least one or several through holes formed in a first substrate of the pressure sensor for providing stress relief and flow connection(s) between the surrounding of the pressure sensor and the gap of the pressure sensor; and
- Fig. 3: shows a schematic cross sectional view of a pressure sensor according to an example having at least one through hole or several through holes formed in a second substrate of the pressure sensor for providing flow connection(s) between the surrounding of the pressure sensor and the gap of the pressure sensor;
- Fig. 4: shows a schematic cross sectional view of a further pressure sensor according to the invention; and
- Fig. 5: shows a representative bottom view of a pressure sensor according to the invention.

Typical examples of applications of pressure sensors according to the invention are e.g. in scientific instrumentation, meteorology, altitude measurement, sound recording, mobile or portable computers and phones etc.

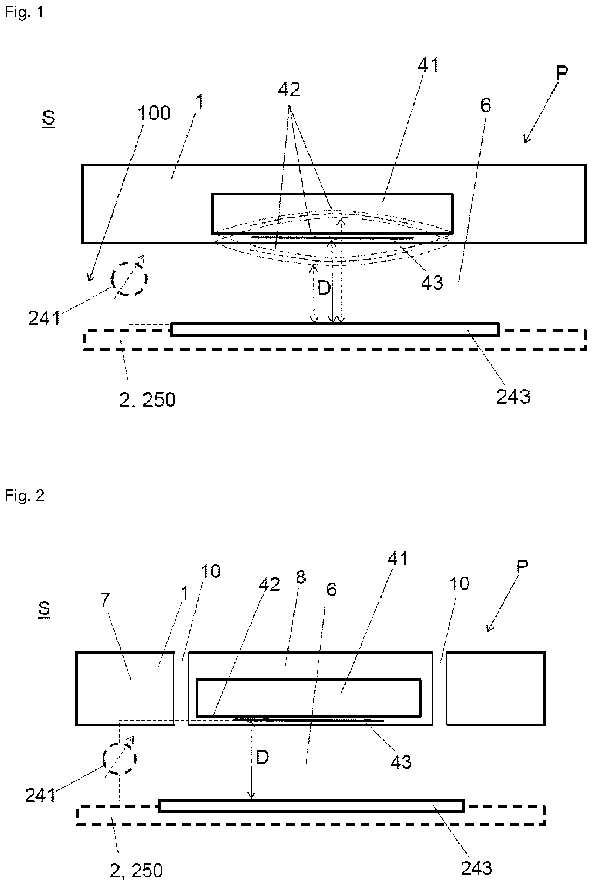

Fig. 1 shows a schematical cross section of a pressure sensor P according to an example. The pressure sensor P comprises a first substrate 1 comprising a cavity 41 and a deformable membrane 42 that is configured to be deformed by a pressure acting on the membrane 42, wherein said membrane separates said cavity 41 from a gap 6 of the pressure sensor P, which gap 6 communicates with a surrounding S of the pressure sensor P (i.e. is in flow connection with said surrounding S) so that the pressure in said gap 6 corresponds to the pressure in the vicinity S of the pressure sensor P.

Further, the pressure sensor P comprises a first electrode 43 comprised by or formed by said membrane 42, wherein the first electrode 43 is moveable with the membrane 42, i.e., when the membrane gets deformed or bent due to a pressure acting on the membrane it takes along the first electrode which deforms accordingly.

Furthermore, the pressure sensor P comprises a stationary second electrode 243 which faces said first electrode 43, wherein said gap 6 is arranged between the second electrode 243 and said membrane 42 comprising the first electrode 43. The first electrode 43/membrane 42 particularly extends parallel to the second electrode 243, related to a flat state of the first electrode 43/membrane 42. Due to a pressure acting on the first electrode 43 or membrane 42, the latter is deformed and may exhibit a curvature, e.g. a convex or concave curvature deviating from an e.g. flat state when the pressure on both sides of the membrane 42 is the same. As an example, such states where the membrane 42 is curved/deformed convex or convace are indicated in Fig. 1 as an illustrative example in dashed lines

Hence, an (e.g. central or average) distance D between the first electrode 43 and the second electrode 243, i.e., the width of said gap 6, depends on the pressure in said gap 6. Here, the central distance D may be the distance between the center of first electrode 43 or membrane 42 and the center of the second electrode 243. However, all other suitably defined distances may also be used/considered.

The pressure sensor P further comprises a processing circuit 241 interacting with the electrodes 43, 243 that is configured to measure such pressure-induced changes in the distance D and therefore the pressure itself e.g. by means of measuring the distance-depending capacity between the electrodes 43, 243.

As indicated schematically by the dashed lines, the second element may be held in a fixed position with respect to the first substrate 1 by means of a holding means 250. Such a holding means may comprise or may be formed as a second substrate 2 that may extend parallel to the first substrate 1 so that said gap is formed between the two substrates.

In order to provide a flow connection between the gap and an outside/surrounding S of the pressure sensor P, the pressure sensor may comprise at least one lateral opening 100, e.g. arranged between the first and the second substrate 1, 2 that connects the surrounding S to the gap 6 so that the pressure inside the gap 6 corresponds to the ambient pressure.

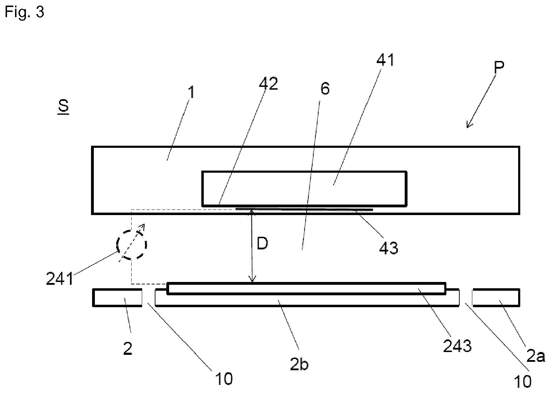

However, according to Figs. 2 and 3, such an opening 100 may also be provided in form of one or several through holes that are formed in the first substrate 1 (cf. Fig. 2) or in the second substrate (if present), cf. Fig. 3. Generally, such openings 100 or through holes 10 may in all embodiments be configured to provide stress relief for mechanically and/or thermally induced stress.

Fig. 2 shows a modified pressure sensor P of the kind shown in Fig. 1, wherein now in contrast to Fig. 1 the pressure sensor P comprises one or several through holes 10 formed in the first substrate 1 which reach through the first substrate 1 for providing said connection between the surrounding S and the gap 6.

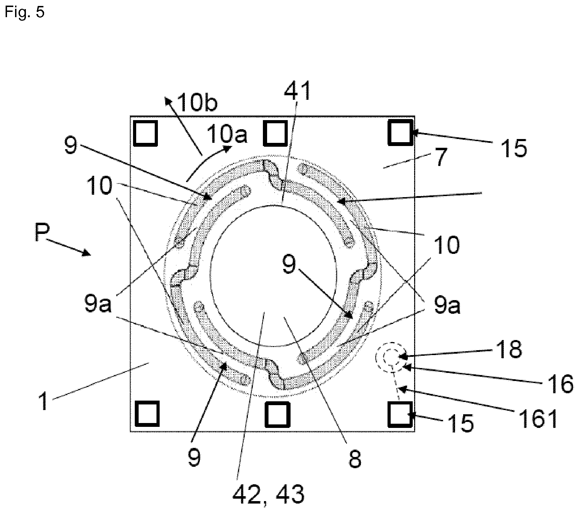

Particularly, as shown in Fig. 5, the through holes 10 may separate a first portion 8 of the substrate 1 comprising the cavity 41, the membrane 42 and first electrode 43, from a second portion 7 of the first substrate 1 via which the sensor P may be connected to further devices. Particularly, each two neighbouring through holes 10 are separated by a suspension element 9, via which suspension elements 9 said first portion 8 is (e.g. integrally) connected to said surrounding second portion 7 of the first substrate 1. Here, said through holes 10 may have an elongated shape and may each extend in a peripheral direction 10a of the first portion 8, wherein each suspension element 9 may comprises a portion 9a that is arranged between two neighbouring elongated through holes 10 in a direction 10b running perpendicular to said peripheral direction 10a as indicated in Fig. 5.

As an alternative example, in case a second substrate 2 is present, the through hole(s) 10 may also be formed in the second substrate 2 as shown in Fig. 3. Here, said through holes may be shaped as described above, but this time separate a first portion 2b of the second substrate 2, which first portion 2b comprises the second electrode 243, from a second portion 2a that surrounds the first portion 2b of the second substrate. Here, a connection to the outside world, i.e., to another device may be provided via the second portion 2a of the second substrate 2.

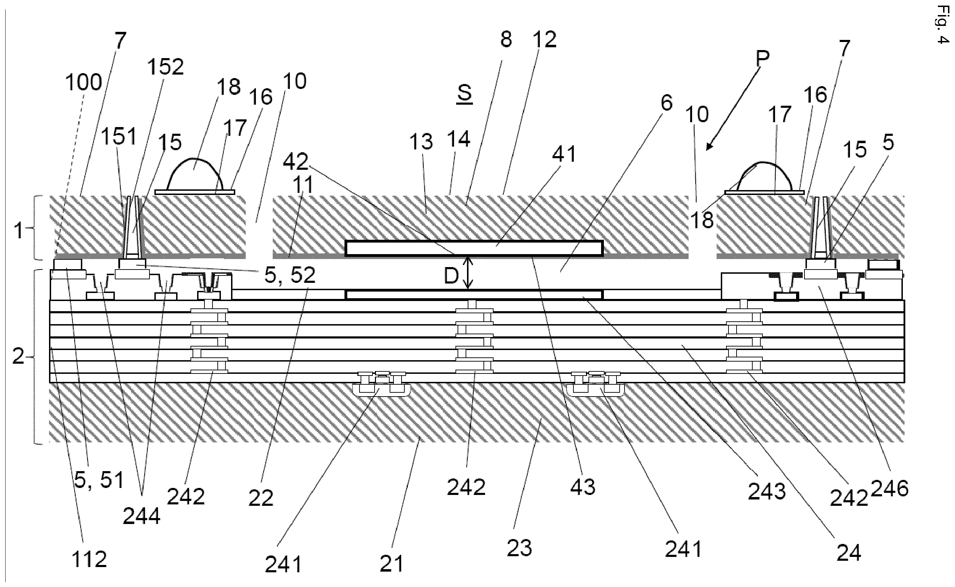

Furthermore, Fig. 4 shows in conjunction with Fig 5 a pressure sensor P in accordance with an embodiment of the present invention. The pressure sensor P as shown is flipped with its optional solder balls 18 showing upwards while the pressure sensor P will be mounted to a carrier (not shown) e.g. with its solder balls 18 sitting on the carrier. Other mechanical and electrical connection means other than solder balls 18 are also possible.

The pressure sensor P includes a first substrate 1 and a second substrate 2 that may serve as a cap for the first substrate 1.

The second substrate 2 particularly is a semiconductor substrate, preferably a silicon substrate, and has a front side 21 and a back side 22 that faces away from the front side 21. The second substrate 2 may contain a bulk material 23 of e.g. silicon and a stack of layers 24 on the bulk material 23. These layers 24 may be arranged for CMOS pro-cessing of the second substrate 2, and as such may also be denoted as CMOS layers or material layers. Specifically, the layers 24 can include for example a plurality of Si02 layers, metal or polysilicon layers. The bulk material 23 may contain doped regions within the silicon such as indicated by the reference sign 241. These components can form active circuitry, such as amplifiers, ND converters or other analog and/or digital signal processing units. A top layer 246 of the stack of layers 24 may be a dielectric layer of silicon oxide and/or silicon nitride protecting the structures below it.

The pressure sensor P further comprises a processing circuit 241 that may be integrated into the second substrate 2, particularly in its front side 21, e.g. by CMOS processing.

The second substrate 2 extends along an extension plane and particularly comprises a flat plate-like geometry. The first substrate 1 also extends along an extension plane and particularly comprises a flat and plate-like geometry, too. The two substrates 1, 2 extend parallel to each other such that a gap 6 is formed between them. Also the first substrate comprises a front side 11 and a back side 12 facing away from the front side, wherein the front side 11 of the first substrate 1 faces the back side of the second substrate 2.

The first substrate 1 may be a semiconductor substrate, e.g. a silicon semiconductor substrate 1 that may comprise a bulk material 13 such as silicon, and one or more layers 14 (not shown in detail), such as an oxide layer on the bulk material 13. The one or more layers 14 may further include for example a plurality of SiO₂ layers, metal or polysilicon layers.

In the front side 11 of the first substrate 1, a cavity 41 is formed, e.g. by one of the ways described above. Particularly, the cavity 41 is a tight cavity, particularly a monocrystalline cavity 41.

The cavity 41 is closed by a deformable membrane 42 with respect to the gap 6 that extends adjacent said membrane 42. The membrane 42 is sufficiently thin such that it deforms depending on a pressure drop between a pressure at the top of the membrane, i.e. in the cavity 41, and below it, i.e. in the gap 6. The pressure in the gap 6 represents the pressure in a surrounding S of the pressure sensor P since the gap 6 is in flow connection with said surrounding S via an opening 10 formed in the first substrate 1 (alternatively such an opening may also be formed in the second substrate 2 or on a lateral side 112 of the pressure sensor, here denoted as opening 100 being arranged between the first and the second substrate 1, 2 as indicated with a dashed line in Fig. 4).

The membrane 42 is particularly formed by an (e.g. doped, conducting) silicon layer, that may be arranged as a sealing lid over the cavity 41 or may form part of an monocrystalline enclosure of the cavity 41, and is used as a first electrode 43 for which reason the deformable membrane 42 may contain electrically conducting material. However, the first electrode may also be a metal layer attached to the membrane or comprised by the membrane 42.

Now, a second electrode 243, which may be a metal layer or formed out of any other suitable electrode material, is arranged on the second substrate 2, particularly on the back side 22 of the latter and faces the first electrode 42 wherein these two electrodes 43, 243 are separated by the vented gap 6.

Hence, upon a change in pressure in the gap 6 that is open to the surrounding S of the pressure sensor P, the membrane 42 deflects and therefore a distance D between the two electrodes 43, 243 that runs in a direction perpendicular to said extensions planes of the substrates 1, 2 as well as perpendicular to the electrodes 43, 243 changes which results in a change of the capacitance between the two electrodes 43, 243 which is measured by the processing circuit 241.

For this, corresponding signals may be transmitted from the electrodes 43, 243, i.e. the deformable membrane 42 and the metal layer 243, via electrically conducting paths 242 to the processing circuit 241 where these signals are processed. Signals processed by the processing circuit 241 may be supplied to the first substrate 1, particularly to electrical contacts 16 arranged on the back side 12 of the first substrate 1.

For making contact to these electrical contacts 16 which may support solder balls 18 for contacting with external devices, the first substrate 1 contains vias 15 reaching vertically (i.e. in a direction normal to the extension plane of the first substrate 1) through the first substrate 1. Particularly, those vias 15 provide for an electrical connection from the front side 11 of the first substrate 1 to its back side 12. Particularly, the vias 15 are manufactured by etching or drilling holes into the first substrate 1 from its back side 12, by applying an oxide 151 to the hole, and by applying conducting material 152 to the oxide 151.

Particularly, at the back side 12 of the first substrate 1, said vias 15 are electrically connected to said electrical contacts 16 (e.g. formed as pads) via conductors 161 (such an electrical connection 161 is shown as an example in Fig. 5 with dashed lines), which electrical contacts 16 may reside on an oxide layer 17 applied to the bulk material 13.

As an alternative to said vias 15 and the solder balls 18, other ways of interconnecting the pressure sensor P to the outside world may also be employed, e.g. by means of wire bonds, bond pads or conducting structures that lead from the front side 11 of the first substrate 1 along its sides to the back side 12 of the first substrate 1. The electrical connection to the outside world may also be implemented via one or more of a Land Grid Array, a Pin Grid Array, or a lead frame.

The second substrate 2 is attached to the front side 11 of the first substrate 1. The attachment may include bonding or other fusion techniques. Particularly, spacers 5 are provided between the second substrate 2 and the first substrate 1. The spacers 5 may have different functions: On the one hand, the spacers 5 provide for said gap 6 between the deformable membrane 42/first electrode 43 and the second substrate/second electrode 243 which is required for supplying the pressure medium via said opening 10 to the membrane 42. On the other hand, some of the spacers 5, but not necessarily all spacers 5 may be electrically conductive and used for connecting (in an electrically conducting fashion) electrically conducting paths 242 of the second substrate 2, particularly via contact windows 244 of the second substrate 2, to the vias 15 or similar structures of the first substrate 1.

Other or the same spacer elements 5 may provide mechanical stability for the stacking of substrates 1 and 2 and / or may provide mechanical protection to the inside of the pressure sensor P, and specifically to the membrane 42. For this purpose, it may be preferred, that a spacer element 51 is arranged e.g. in form of a ring at the edges of the substrates 1, 2 providing mechanical stability, protection as well as an electrical connection, while spacer elements 52 are rather pillar-like and provide electrical connections.

The output signals provided by the processing circuit 241 hence may be transferred via one or more of the electrical paths 242 and via one or more of the contact windows 244 to one or more of the spacer elements 5. As shown in Fig. 4, the spacer elements 52 end at the vias 15 of the first substrate 1 and are electrically connected thereto. Hence, the signals are conducted through the vias 15 to the electrical contacts (e.g. pads) 16 and the solder balls 18.

Furthermore (cf. particularly Fig. 5), the first substrate 1 contains a first portion 8 and a second portion 7 that is (e.g. integrally) connected via suspension elements 9 to the first portion 7. Particularly, the second portion 7 encompasses the first portion 8 in the extension plane of the first substrate 1.

Here, the first portion 8 is separated from the second portion 7 of the first substrate by several through holes 10 in the form of elongated through holes or trenches 10 that are arranged around the first portion 8 along a peripheral direction 10a of the first portion 8 (cf. Fig. 5). Owed to the manufacturing of the first portion 8 and the second portion 7 from the common first substrate 1, both portions may include bulk material 13 from the first substrate 1.

Preferably, the elongated through holes extend such in a peripheral direction 10a of the first portion 8 of the first substrate, that each suspension element 9 comprises an (elongated) portion 9a that is arranged between two neighbouring elongated through holes in a direction 10b running perpendicular to said peripheral direction 10a, i.e., in a radial direction.

The second substrate 2 is particularly exclusively attached to the second portion 7 of the first substrate 1 via the spacer elements 5. Further, it is preferred that it is solely the second portion 7 that provides a mechanical and electrical contact to the outside world (i.e. to another device), e.g. via the solder balls 18/electrical contacts 16 which are preferably provided on the second portion 7 of the first substrate (i.e. outside the first portion 8).

Here, the elongated through holes 10 also serve as stress relief trenches that protect the first portion that comprises the cavity 41 and the membrane 42/first electrode 43 when the pressure sensor is connected to the outside world, i.e., to other devices.

Due to the distribution of the through holes 10/suspension elements 9 around the first portion 8, mechanically and thermally induced stress can be decoupled, particularly mechanical vibrations of the first portion 8 and thus of the membrane/first electrode 42, 43 with respect to the second electrode 243, as well as can be sufficiently suppressed.

The overall height of the pressure sensor in the present example is about 400 µm.

Further, Fig. 5 illustrates a bottom view onto the first substrate 1 of the pressure sensor P. According thereto, the first portion 8 is suspended from the second portion 7 of the first substrate by means of said suspension elements 9, which forms an (e.g. integral) mechanical link between the two portions 7 and 8. As already indicated above, each such link particularly comprises a portion 9a that extends along the peripheral direction 10a of the first portion 8 and is arranged between two through hole portions that face each other in said radial direction 10b of the first portion 8. As further indicated, in case vias 15 are used, they are arranged in the second portion 7 like the electrical contacts 16 and solder balls 18. The first portion 8, e.g. the first electrode, may be electrically connected to the second portion 7 by means of electrically conducting structures that extend along said links 9, 9a (not shown). Also shown as an example is an electrical connection between an electrical contact 16 and a via 15 by means of an electrically conducting structure 161 which electrically conducting structures may in generally be denoted as redistribution layer. These electrically conducting structures or conductors 161 may extend via the second portion 7 to the vias 15 located therein.

## Claims

1. A pressure sensor for sensing a pressure, comprising:
a first substrate (1) comprising a cavity (41) and a deformable membrane (42) that is configured to be deformed by a pressure acting on the membrane (42), wherein said membrane separates said cavity (41) from a gap (6) of the pressure sensor (P), wherein said gap (6) communicates with a surrounding (S) of the pressure sensor (P) so that the pressure in said gap (6) corresponds to the pressure in said surrounding (S),
a first electrode (43) comprised or formed by said membrane (42), wherein the first electrode (43) is moveable with the membrane (42), and
a stationary second electrode (243) which faces said first electrode (43), wherein said gap (6) is arranged between the second electrode (243) and said membrane (42) comprising the first electrode (43), so that a distance (D) between the first electrode (43) and the second electrode (243) depends on the pressure in said gap (6),
**characterized in that** the pressure sensor (P) comprises several through holes (10) via which said gap (6) communicates with said surrounding (S) of the pressure sensor (P), wherein said through holes (10) extend through the first substrate (1),
wherein said through holes (10) extend to separate a first portion (8) of the first substrate (1) from a surrounding second portion (7) of the first substrate (1), and wherein said first portion (8) is connected via suspension elements (9) to the surrounding second portion (7) of the first substrate (1).

2. The pressure sensor according to claim 1, wherein the pressure sensor comprises a second substrate (2) facing the first substrate (1), wherein the second substrate (2) comprises said second electrode (243).

3. The pressure sensor according to claim 1, wherein the second electrode (243) is connected to a holding means (250) connected to or protruding from the first substrate (1).

4. The pressure sensor according to one of the preceding claims, wherein the pressure sensor (P) comprises a processing circuit (241), which is configured to measure a capacitance between the first and the second electrode (43, 243), wherein the processing circuit (241) is configured to derive an output signal from said capacitance corresponding to the pressure in said gap (6).

5. The pressure sensor according to claim 4, when dependent upon claim 2, wherein the processing circuit (241) is integrated into the second substrate (2), or wherein the processing circuit (241) is integrated into the first substrate (1).

6. The pressure sensor according to one of the preceding claims, wherein the pressure sensor (P) comprises electrical contacts (16) that are configured for electrically connecting the pressure sensor (P) to a further device, wherein said electrical contacts (16) each support a solder ball (18).

7. The pressure sensor according to claim 6, when dependent upon claim 2, wherein the electrical contacts (16) are arranged on the first substrate (1) or on the second substrate (2).

8. The pressure sensor according to claim 2 or one of the claims 3 to 7 when dependent upon claim 2, wherein the second substrate (2) is supported via spacers (5) on the first substrate (1).

9. The pressure sensor according to claim 2 or any of claims 4 to 8, when dependent upon claim 2, wherein the pressure sensor (P) comprises at least one lateral opening (100) via which said gap (6) communicates with said surrounding (S) of the pressure sensor (P), wherein said at least one lateral opening (100) is arranged on a lateral side (112) of the pressure sensor (P) between the first and the second substrate (2).

10. The pressure sensor according to claim 6, when dependent upon claim 2, wherein the first portion (8) comprises the cavity (41), and/or said membrane (42), and wherein said electrical contacts (16) are arranged on the second portion (7) of the first substrate (1) or on the second substrate (2).

11. The pressure sensor according to claim 1 or 10, wherein said through holes (10) are elongated through holes that each extend in a peripheral direction (10a) of the first portion (8), wherein each suspension element (9) comprises a portion (9a) that is arranged between two neighbouring elongated through holes (10) in a direction (10b) running perpendicular to said peripheral direction (10a).

12. The pressure sensor according to claim 8 or any of claims 9 to 11 when dependent upon claim 8, wherein the second portion (7) supports the second substrate (2) via said spacers (5), wherein the first portion (8) is suspended from the second portion (8) via said suspension elements (9).

13. A method for manufacturing a pressure sensor (P) according to one of the preceding claims, wherein at least a first substrate (1) is provided, wherein a cavity (41) is formed in the first substrate (1), wherein a deformable membrane (42) closing said cavity (41) and comprising a first electrode (43) is formed, wherein a second electrode (243) is provided, and wherein the first substrate (1) and the second electrode (243) are connected such that the second electrode (243) faces the first electrode (43) and a gap (6) is formed between the two electrodes (43, 243) that communicates with a surrounding (S) of the pressure sensor (P), and wherein several though holes (10) are formed into the first substrate (1) such that they extend to separate a first portion (8) of the first substrate (1) from a surrounding second portion (7) of the first substrate (1) such that said first portion (8) of the first substrate (1) is connected via suspension elements (9) to the surrounding second portion (7) of the first substrate (1).

## Patentansprüche

1. Drucksensor zum Erfassen eines Drucks, der Folgendes umfasst:
ein erstes Substrat (1), das einen Hohlraum (41) und eine verformbare Membran (42) umfasst, die dazu ausgelegt ist, durch einen Druck, der auf die Membran (42) wirkt, verformt zu werden, wobei die Membran den Hohlraum (41) von einem Spalt (6) des Drucksensors (P) trennt, wobei der Spalt (6) mit einer Umgebung (S) des Drucksensors (P) kommuniziert, derart, dass der Druck im Spalt (6) dem Druck in der Umgebung (S) entspricht,
eine erste Elektrode (43) die von der Membran (42) umfasst oder gebildet ist, wobei die erste Elektrode (43) mit der Membran (42) bewegbar ist, und
eine stationäre zweite Elektrode (243), die der ersten Elektrode (43) zugewandt ist, wobei der Spalt (6) zwischen der zweiten Elektrode (243) und der Membran (42), die die erste Elektrode (43) umfasst, angeordnet ist, derart, dass ein Abstand (D) zwischen der ersten Elektrode (43) und der zweiten Elektrode (243) vom Druck im Spalt (6) abhängig ist,
**dadurch gekennzeichnet, dass**
der Drucksensor (P) mehrere Durchgangslöcher (10) umfasst, via die der Spalt (6) mit der Umgebung (S) des Drucksensors (P) kommuniziert, wobei sich die Durchgangslöcher (10) durch das erste Substrat (1) erstrecken,
wobei die Durchgangslöcher (10) sich erstrecken, um einen ersten Abschnitt (8) des ersten Substrats (1) von einem umgebenden zweiten Abschnitt (7) des ersten Substrats (1) zu trennen, und wobei der erste Abschnitt (8) via Aufhängungselemente (9) mit dem zweiten Abschnitt (7) des Substrats (1) verbunden ist.

2. Drucksensor nach Anspruch 1, wobei der Drucksensor ein zweites Substrat (2) umfasst, das dem ersten Substrat (1) zugewandt ist, wobei das zweite Substrat (2) eine zweite Elektrode (243) umfasst.

3. Drucksensor nach Anspruch 1, wobei die zweite Elektrode (243) mit einem Haltemittel (250) verbunden ist, das mit dem ersten Substrat (1) verbunden ist oder von diesem vorsteht.

4. Drucksensor nach einem der vorhergehenden Ansprüche, wobei der Drucksensor (P) eine Verarbeitungsschaltung (241) umfasst, die dazu ausgelegt ist, eine Kapazität zwischen der ersten und der zweiten Elektrode (43, 243) zu messen, wobei die Verarbeitungsschaltung (241) dazu ausgelegt ist, ein Ausgangssignal von der Kapazität, die dem Druck im Spalt (6) entspricht, abzuleiten.

5. Drucksensor nach Anspruch 4, wenn von Anspruch 2 abhängig, wobei die Verarbeitungsschaltung (241) in das zweite Substrat (2) integriert ist oder wobei die Verarbeitungsschaltung (241) in das erste Substrat (1) integriert ist.

6. Drucksensor nach einem der vorhergehenden Ansprüche, wobei der Drucksensor (P) elektrische Kontakte (16) umfasst, die zum elektrischen Verbinden des Drucksensors (P) mit einer weiteren Vorrichtung ausgelegt sind, wobei die elektrischen Kontakte (16) jeweils eine Lotkugel (18) stützen.

7. Drucksensor nach Anspruch 6, wenn von Anspruch 2 abhängig, wobei die elektrischen Kontakte (16) auf dem ersten Substrat (1) oder auf dem zweiten Substrat (2) angeordnet sind.

8. Drucksensor nach Anspruch 2 oder einem der Ansprüche 3 bis 7, wenn von Anspruch 2 abhängig, wobei das zweite Substrat (2) via Abstandhalter (5) auf dem ersten Substrat (1) gestützt ist.

9. Drucksensor nach Anspruch 2 oder einem der Ansprüche 4 bis 8, wenn von Anspruch 2 abhängig, wobei der Drucksensor (P) mindestens eine seitliche Öffnung (100) umfasst, via die der Spalt (6) mit der Umgebung (S) des Drucksensors (P) kommuniziert, wobei die mindestens eine seitliche Öffnung (100) auf einer seitlichen Seite (112) des Drucksensors (P) zwischen dem ersten und dem zweiten Substrat (2) angeordnet ist.

10. Drucksensor nach Anspruch 6, wenn von Anspruch 2 abhängig, wobei der erste Abschnitt (8) den Hohlraum (41) und/oder die Membran (42) umfasst und wobei die elektrischen Kontakte (16) auf dem zweiten Abschnitt (7) des ersten Substrats (1) oder auf dem zweiten Substrat (2) angeordnet sind.

11. Drucksensor nach Anspruch 1 oder 10, wobei die Durchgangslöcher (10) längliche Durchgangslöcher sind, die sich jeweils in eine Umfangsrichtung (10a) des ersten Abschnitts (8) erstrecken, wobei jedes Aufhängungselement (9) einen Abschnitt (9a) umfasst, der zwischen zwei benachbarten länglichen Durchgangslöchern (10) in eine Richtung (10b), die senkrecht zur Umfangsrichtung (10a) verläuft, angeordnet ist.

12. Drucksensor nach Anspruch 8 oder einem der Ansprüche 9 bis 11, wenn von Anspruch 8 abhängig, wobei der zweite Abschnitt (7) das zweite Substrat (2) via die Abstandhalter (5) stützt, wobei der erste Abschnitt (8) vom zweiten Abschnitt (8) via die Aufhängungselemente (9) aufgehängt ist.

13. Verfahren zum Herstellen eines Drucksensors (P) nach einem der vorhergehenden Ansprüche, wobei mindestens ein erstes Substrat (1) bereitgestellt ist, wobei ein Hohlraum (41) im ersten Substrat (1) gebildet ist, wobei eine verformbare Membran (42), die den Hohlraum (41) schließt und eine erste Elektrode (43) umfasst, gebildet ist, wobei eine zweite Elektrode (243) bereitgestellt ist und wobei das erste Substrat (1) und die zweite Elektrode (243) verbunden sind, derart, dass die zweite Elektrode (243) der ersten Elektrode (43) zugewandt ist und zwischen den zwei Elektroden (43, 243) ein Spalt (6) gebildet ist, der mit einer Umgebung (S) des Drucksensors (P) kommuniziert, und wobei mehrere Durchgangslöcher (10) in das erste Substrat (1) gebildet sind, derart, dass sie sich erstrecken, um einen ersten Abschnitt (8) des ersten Substrats (1) von einem umgebenden zweiten Abschnitt (7) des ersten Substrats (1) zu trennen, derart, dass der erste Abschnitt (8) des ersten Substrats (1) via Aufhängungselemente (9) mit dem umgebenden zweiten Abschnitt (7) des ersten Substrats (1) verbunden ist.

## Revendications

1. Capteur de pression pour détecter une pression, comprenant :
un premier substrat (1) comprenant une cavité (41) et une membrane déformable (42) qui est configurée pour être déformée par une pression agissant sur la membrane (42), ladite membrane séparant ladite cavité (41) d'un intervalle (6) du capteur de pression (P), ledit intervalle (6) communiquant avec un environnement (S) du capteur de pression (P) de sorte que la pressure dans ledit intervalle (6) correspond à la pression dans ledit environnement (S),
une première électrode (43) comprise ou formée par ladite membrane (42), la première électrode (43) pouvant être déplacée avec la membrane (42), et
une deuxième électrode stationnaire (243) faisant face à ladite première électrode (43), ledit intervalle (6) étant agencé entre la deuxième électrode (243) et ladite membrane (42) comprenant la première électrode (43), de sorte qu'une distance (D) entre la première électrode (43) et la deuxième électrode (243) dépend de la pression dans ledit intervalle (6),
**caractérisé en ce que** le capteur de pression (P) comprend plusieurs trous traversants (10) par l'intermédiaire desquels ledit intervalle (6) communique avec l'environnement (S) du capteur de pression (P), dans lequel lesdits trous traversants (10) s'étendent à travers le premier substrat (1),
dans lequel les trous traversants (10) s'étendent pour séparer une première portion (8) du premier substrat (1) d'une deuxième portion (7) environnante du premier substrat (1), et dans lequel ladite première portion (8) est connectée par l'intermédiaire d'éléments de suspension (9) à la deuxième portion (7) environnante du premier substrat (1).

2. Capteur de pression selon la revendication 1, dans lequel le capteur de pression comprend un deuxième substrat (2) faisant face au premier substrat (1), le deuxième substrat (2) comprenant ladite deuxième électrode (243).

3. Capteur de pression selon la revendication 1, dans lequel la deuxième électrode (243) est connectée à un moyen de maintien (250) connecté au, ou dépassant du premier substrat (1).

4. Capteur de pression selon l'une quelconque des revendications précédentes, dans lequel le capteur de pression (P) comprend un circuit de traitement (241), qui est configuré pour mesurer une capacité entre la première et la deuxième électrode (43, 243), dans lequel le circuit de traitement (241) est configuré pour dériver un signal de sortie de ladite capacité correspondant à la pression dans ledit intervalle (6).

5. Capteur de pression selon la revendication 4 lorsqu'elle dépend de la revendication 2, dans lequel le circuit de traitement (241) est intégré dans le deuxième substrat (2), ou dans lequel le circuit de traitement (241) est intégré dans le premier substrat (1) .

6. Capteur de pression selon l'une quelconque des revendications précédentes, dans lequel le capteur de pression (P) comprend des contacts électriques (16) qui sont configurés pour connecter électriquement le capteur de pression (P) à un dispositif supplémentaire, lesdits contacts électriques (16) portant chacun une bille de soudure (18).

7. Capteur de pression selon la revendication 6, lorsqu'elle dépend de la revendication 2, dans lequel les contacts électriques (16) sont agencés sur le premier substrat (1) ou sur le deuxième substrat (2).

8. Capteur de pression selon la revendication 2 ou l'une des revendications 3 à 7 lorsqu'elle dépend de la revendication 2, dans lequel le deuxième substrat (2) est porté par l'intermédiaire d'entretoises (5) sur le premier substrat (1).

9. Capteur de pression selon la revendication 2 ou l'une des revendications 4 à 8, lorsqu'elle dépend de la revendication 2, dans lequel le capteur de pression (P) comprend au moins une ouverture latérale (100) par l'intermédiaire de laquelle ledit intervalle (6) communique avec ledit environnement (S) du capteur de pression (P), ladite au moins une ouverture latérale (100) étant agencée sur un côté latéral (112) du capteur de pression (P) entre le premier et le deuxième substrat (2).

10. Capteur de pression selon la revendication 6, lorsqu'elle dépend de la revendication 2, dans lequel la première portion (8) comprend la cavité (41), et/ou ladite membrane (42), et dans lequel lesdits contacts électriques (16) sont agencés sur la deuxième portion (7) du premier substrat (1) ou sur le deuxième substrat (2) .

11. Capteur de pression selon la revendication 1 ou 10, dans lequel lesdits trous traversants (10) sont des trous traversants allongés qui s'étendent chacun dans une direction périphérique (10a) de la première portion (8), dans lequel chaque élément de suspension (9) comprend une portion (9a) qui est agencée entre deux trous traversants allongés (10) voisins dans une direction (10b) s'étendant perpendiculairement à ladite direction périphérique (10a).

12. Capteur de pression selon la revendication 8 ou l'une des revendications 9 à 11 lorsqu'elle dépend de la revendication 8, dans lequel la deuxième portion (7) porte le deuxième substrat (2) par l'intermédiaire desdites entretoises (5), la première portion (8) étant suspendue à la deuxième portion (8) par l'intermédiaire desdits éléments de suspension (9).

13. Procédé de fabrication d'un capteur de pression (P) selon l'une quelconque des revendications précédentes, dans lequel au moins un premier substrat (1) est prévu, dans lequel une cavité (41) est formée dans le premier substrat (1), dans lequel une membrane déformable (42) fermant ladite cavité (41) et comprenant une première électrode (43) est formée, dans lequel une deuxième électrode (243) est prévue, et dans lequel le premier substrat (1) et la deuxième électrode (243) sont connectés de telle sorte que la deuxième électrode (243) fait face à la première électrode (43) et un intervalle (6) est formé entre les deux électrodes (43, 243) qui communiquent avec un environnement (S) du capteur de pression (P), et dans lequel plusieurs trous traversants (10) sont formés dans le premier substrat (1) de sorte qu'ils s'étendent pour séparer une première portion (8) du premier substrat (1) d'une deuxième portion environnante (7) du premier substrat (1) de sorte que ladite première portion (8) du premier substrat (1) est connectée par l'intermédiaire d'éléments de suspension (9) à la deuxième portion environnante (7) du premier substrat (1) .
